# EUROPEAN PATENT APPLICATION

(11) **EP 3 079 167 A1**
(43) Date of publication of application: **12.10.2016**
(21) Application number: 14868102.6
(22) Date of filing: 27.11.2014
(51) Int. Cl.: H01L 21/677, B25J 15/06, B65G 49/06, B65G 49/07

(54) **HOLDING DEVICE**

(30) Priority: 03.12.2013 JP 2013250225
(71) Applicant: Harmotec Co., Ltd., Kofu City Yamanashi 400-0851 (JP)
(72) Inventor: IWASAKA Hitoshi, Kofu City Yamanashi 400-0851 (JP); TOKUNAGA Hideyuki, Kofu City Yamanashi 400-0851 (JP); KASAI Yuji, Kofu City Yamanashi 400-0851 (JP); KOSHIISHI Katsuhiro, Kofu City Yamanashi 400-0851 (JP)
(74) Representative: Stebbing, Timothy Charles
(86) International application number: PCT/JP2014/081386
(87) International publication number: WO 2015/083613

(57) **Abstract**

Holding equipment for holding a plate-like member by discharging fluid to generate a negative pressure between the holding equipment and the member, includes a columnar main body, a flat end face formed at the main body, that faces the member, a concave part formed at the end face, one or more fluid passages that discharge fluid into the concave part to form a swirl flow or a radial flow, and a liquid supply means for supplying a part of the member with a liquid, the part facing the centre of the swirl flow or the radial centre of the radial flow.

## Description

### Technical field

The present invention pertains to holding equipment.

### Background art

In recent years, equipment for conveying a plate-like member such as a semiconductor wafer or a glass substrate in a non-contact manner has been developed. For example, in Patent Document 1, equipment is proposed for conveying a plate-like member in a non-contact manner, by applying Bernoulli's principle. The equipment includes a cylindrical chamber that opens on the underside of the equipment, into which fluid is supplied to generate a swirl flow. The swirl flow generates a negative pressure in the centre, which exerts suction on the plate-like member. On the other hand, a fluid flowing out of the cylindrical chamber causes a given distance to be maintained between the equipment and the plate-like member. Consequently, the equipment conveys the plate-like member in a non-contact manner.

### Prior Art Document

### Patent Document

Patent Document 1: JP 2005-51260 A1

### Summary of the Invention

### Problems to be solved by the Invention

It is an object of the present invention to prevent a water mark from being formed on a part of a plate-like member held by holding equipment that discharges fluid to form a swirl flow or a radial flow so that a negative pressure is generated between the holding equipment and the member, the part facing the centre of the swirl flow or the radial centre of the radial flow.

### Means for Solving the Problems

The present invention provides holding equipment for holding a plate-like member by discharging fluid to generate a negative pressure between the holding equipment and the member, the holding equipment comprising: a columnar main body; a flat end face formed at the main body, that faces the member; a concave part formed at the end face; one or more fluid passages that discharge fluid into the concave part to form a swirl flow or a radial flow; and a liquid supply means for supplying a part of the member with a liquid, the part facing the centre of the swirl flow or the radial centre of the radial flow.

In the above holding equipment, the liquid supply means may comprise a discharge port that faces the part of the member, and the liquid supply means may discharge liquid onto the part of the member via the discharge port.

In the above holding equipment, liquid that is discharged onto the part of the member via the discharge port may be discharged onto the part of the member by suction exerted by the negative pressure that occurs between the holding equipment and the member.

In the above holding equipment, the one or more fluid passages may discharge liquid into the concave part to form a swirl flow, and the liquid supply means may be a projecting part formed on a wall surface of the main body, the wall surface facing the concave part.

In the above holding equipment, the one or more fluid passages may discharge liquid into the concave part to form a swirl flow or a radial flow, and the liquid supply means may be attached to the end face, and may hold liquid particles discharged by the one or more fluid passages, in a position that faces the part of the member.

In the above holding equipment, the fluid may be a gas.

### Effects of the Invention

The present invention is able to prevent a water mark from being formed on a part of a plate-like member held by holding equipment that discharges fluid to form a swirl flow or a radial flow so that a negative pressure is generated between the holding equipment and the member, the part facing the centre of the swirl flow or the radial centre of the radial flow.

### Brief Description of the Drawings

Fig. 1 is a perspective view illustrating one example of a swirl flow-forming body 1.
Fig. 2 is a cross-sectional view of fig. 1 along line A-A.
Fig. 3 is a cross-sectional view of fig. 1 along line B-B.
Fig. 4 is a perspective view illustrating one example of a swirl flow-forming body 3.
Fig. 5 is a cross-sectional view of fig. 4 along line C-C.
Fig. 6 is a cross-sectional view of fig. 4 along line D-D.
Fig. 7 is a perspective view of conveyance equipment 10.
Fig. 8 is a perspective view illustrating one example of a swirl flow-forming body 5.
Fig. 9 is a cross-sectional view of fig. 8 along line E-E.
Fig. 10 is a cross-sectional view of fig. 8 along line F-F.
Fig. 11 is a plane view of a baffle plate 6.
Fig. 12 is a drawing explaining the effects of baffle plate 6.
Fig. 13 is a perspective view illustrating one example of a radial flow-forming body 7.
Fig. 14 is a bottom view of radial flow-forming body 7.
Fig. 15 is a cross-sectional view of fig. 13 along line G-G
Fig. 16 is a plane view of a baffle plate 6A.
Fig. 17 is a drawing illustrating one example of the configuration of conveyance equipment 30.
Fig. 18 is a cross-sectional view of fig. 17 along line H-H.
Fig. 19 is a cross-sectional view of fig. 18 along line I-I.
Fig. 20 is a drawing illustrating one example of the configuration of conveyance equipment 50.
Fig. 21 is a cross-sectional view of fig. 20 along line J-J.

### Description of Reference Numerals

1... swirl flow-forming body, 3... swirl flow-forming body, 5... swirl flow-forming body, 6... baffle plate, 7... radial flow-forming body, 10... conveyance equipment, 11... main body, 12... concave part, 13... end face, 14... jetting port, 15... slope, 16... convex part, 17... discharge port, 18... introduction port, 19... introduction path, 20... annular passage, 21... communication passage, 22... supply port, 23... supply path, 30... conveyance equipment, 31... main body, 32... concave part, 33... end face, 34... jetting port, 35... slope, 36... projecting part, 37... annular passage, 38... communication passage, 39... supply port, 40... supply path, 50... conveyance equipment, 51... main body, 52... concave part, 53... end face, 54... jetting ports, 55... slope, 56... supply port, 57... annular passage, 58... communication passage, 59... supply path, 61... disk part, 62... rod-like member, 63... annular member, 71... main body, 72... annular concave part, 73... end face, 74... opposing surface, 75... slope, 76... discharge port, 77... nozzle hole, 78... introduction path, 79... introduction port, 80... annular passage, 81... communication passage, 82... supply port, 201... base body, 202... friction member, 203... hole, 204... supply port, 205... communication passage, 206... annular passage, 301... base body, 302... supply port, 303... C-shaped passage, 304... communication passage, 3011... holding part, 3012... arm

### Modes for Implementing the Invention

The mode for carrying out the present invention is explained below with reference to the drawings.

### 1. First embodiment

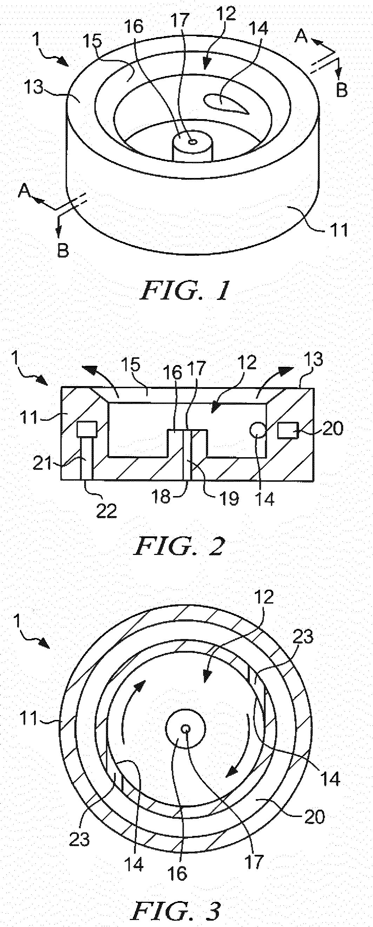

Fig. 1 is a perspective view illustrating one example of a swirl flow-forming body 1 as in a first embodiment of the present invention. Fig. 2 is a cross-sectional view of fig. 1 along line A-A. Fig. 3 is a cross-sectional view of fig. 1 along line B-B. Swirl flow-forming body 1 is equipment for holding a plate-like member W such as a semiconductor wafer or a glass base body and conveying the member. Swirl flow-forming body 1 holds said member by discharging fluid to generate negative pressure between the equipment and plate-like member W. Here, a fluid is a gas such as compressed air or a liquid such as pure water or carbonated water, for example. The material of swirl flow-forming body 1 is an aluminium alloy, for example. This swirl flow-forming body 1 is one example of the "holding equipment" as in the present invention.

Swirl flow-forming body 1, as illustrated in fig. 1-3, is provided with a main body 11, a concave part 12, an end face 13, two jetting ports 14, a slope 15, a convex part 16 and a discharge port 17. Main body 11 has a column shape. End face 13 is formed in a flat shape on one of the surfaces (specifically, the surface that faces plate-like member W, which is an article to be conveyed) (hereafter referred to as "bottom face") of main body 11. Concave part 12 has a column shape and is formed in end face 13. Concave part 12 is formed on the same axis as main body 11.

Two jetting ports 14 are formed on the inner-peripheral side surface of main body 11 that faces concave part 12. The two jetting ports 14 are arranged so as to mutually oppose each other. Specifically, jetting ports 14 are arranged in point symmetry about the axial centre of the central axis of main body 11 or concave part 12. The fluid supplied to swirl flow-forming body 1 is discharged into concave part 12 via each of jetting ports 14. Slope 15 is formed on the opening end of concave part 12.

Convex part 16 has a column shape, and is formed so as to extend from the bottom of concave part 12. Convex part 16 is formed on the same axis as main body 11 or concave part 12. The top face (specifically, the surface that opposes plate-like member W, which is an article to be conveyed) of convex part 16 is formed in a recessed manner with respect to end face 13. Convex part 16 forms a fluid flow path between the outer-circumferential side surface thereof and the inner-peripheral side surface of main body 11, and fluid that is discharged into concave part 12 forms a swirl flow by flowing through this fluid flow path. Discharge port 17 has a circular shape, and is provided in the centre of the top face of convex part 16. This discharge port 17 communicates with an introduction path 19 described below, and discharges liquid such as pure water or carbonated water.

Swirl flow-forming body 1, as illustrated in figs. 2 and 3, is also provided with an introduction port 18, an introduction path 19, an annular passage 20, a communication passage 21, a supply port 22 and two supply paths 23. Introduction port 18 has a circular shape, and is provided in the centre of the top face (that is, the surface opposite the bottom face) of main body 11. Introduction port 18 is connected to a liquid tank (not illustrated) via a tube, for example, and liquid is supplied into main body 11 via this introduction port 18. Introduction path 19 is provided inside main body 11, and extends in a straight line along the central axis of main body 11. Introduction path 19 communicates with introduction port 18 at one end thereof, and communicates with discharge port 17 described above at the other end thereof.

Annular passage 20 has a cylindrical shape, and is formed inside main body 11 so as to surround concave part 12. Annular passage 20 is formed on the same axis as concave part 12. Annular passage 20 supplies supply path 23 with fluid supplied from communication passage 21. Communication passage 21 is provided inside main body 11, and extends in a straight line parallel to the central axis of main body 11. Communication passage 21 communicates with annular passage 20 at one end thereof, and communicates with supply port 22 at the other end thereof. Supply port 22 has a circular shape, and is provided on the top face of main body 11. Supply port 22 is connected to fluid supply equipment (not illustrated) via a tube, for example, and fluid is supplied into main body 11 via this supply port 22.

Each of the two supply paths 23 discharges a fluid into concave part 12 via jetting ports 14 to form a swirl flow within concave part 12. Specifically, each of supply paths 23 is formed so as to be approximately parallel to end face 13 and to extend in a direction tangential to the outer circumference of concave part 12, one end thereof communicating with annular passage 20 and the other end communicating with jetting ports 14. Supply paths 23 are one example of the "fluid passage" in the present invention.

If swirl flow-forming body 1 is supplied with fluid via supply port 22 as explained above, the fluid passes through communication passage 21, annular passage 20 and supply paths 23 before being discharged from jetting ports 14 into concave part 12. The fluid discharged into concave part 12 forms a swirl flow and is straightened in concave part 12, and subsequently flows out from the opening of concave part 12. At this time, if a plate-like member W is positioned opposite end face 13, inflow of external fluid (for example, air or water) to concave part 12 is restricted, and the density of fluid molecules per unit volume in the centre of the swirl flow becomes reduced due to centrifugal force and entrainment effect of the swirl flow, generating negative pressure between swirl flow-forming body 1 and plate-like member W. As a result, plate-like member W is pushed by surrounding fluid and is drawn towards end face 13. On the other hand, as the distance between end face 13 and plate-like member W decreases, the amount of fluid that flows out of concave part 12 becomes limited, the speed of fluid discharged from jetting ports 14 into concave part 12 decreases, and the pressure in the centre of the swirl flow increases. As a result, plate-like member W does not come into contact with end face 13, and a given distance is maintained between plate-like member W and end face 13.

If plate-like member W is conveyed by swirl flow-forming body 1 in a washed and wet state, a swirl flow forms within concave part 12 as described above, and thus liquid adhered to plate-like member W scatters in an outer-circumferential direction thereof due to the centrifugal force of said swirl flow. As a result, in conveyance equipment that uses a conventional swirl flow, there was a problem of the surface of plate-like member W becoming dry, and so-called water marks (in other words, water staining) forming on said surface. A water mark, when plate-like member W is a semiconductor wafer, is composed of an oxide, for example.

By contrast, in swirl flow-forming body 1 as in the present embodiment, liquid inside introduction path 19 is sucked and discharged from discharge port 17 due to negative pressure that occurs between swirl flow-forming body 1 and plate-like member W. The discharged liquid is supplied to the surface (specifically, the central part of the surface) of plate-like member W that opposes discharge port 17. In other words, said liquid is supplied to the surface part of plate-like member W, which part faces the centre of the swirl flow. Said liquid is directly supplied from directly above the central part of said surface via discharge port 17. Liquid supplied to the central part of the surface of plate-like member W spreads to the entire surface of plate-like member W due to the centrifugal force of the swirl flow. As a result, drying of the surface of plate-like member W is prevented, thereby preventing water marks from forming.

In swirl flow-forming body 1, the combination of discharge port 17, introduction port 18 and introduction path 1 is one example of the "liquid supply means" as in the present invention.

### 2. Second embodiment

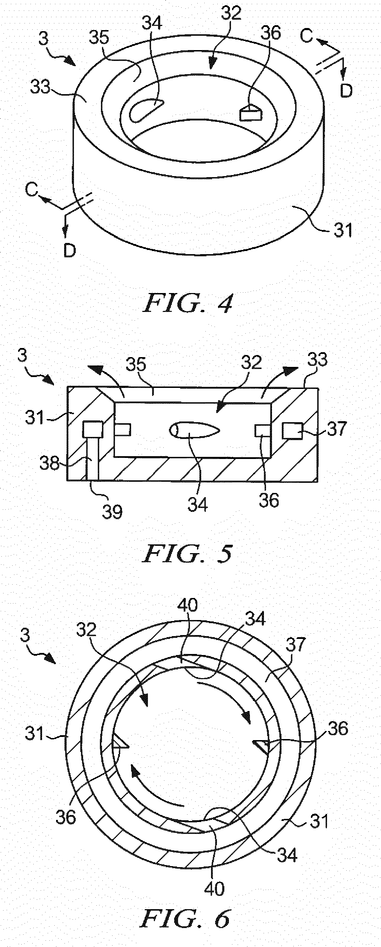

Fig. 4 is a perspective view illustrating one example of a swirl flow-forming body 3 as in a second embodiment of the present invention. Fig. 5 is a cross-sectional view of fig. 4 along line C-C. Fig. 6 is a cross-sectional view of fig. 4 along line D-D. Swirl flow-forming body 3 is equipment for holding a plate-like member W such as a semiconductor wafer or a glass base body and conveying the member. Swirl flow-forming body 3 holds said member by discharging liquid such as pure water or carbonated water to generate negative pressure between the equipment and plate-like member W. The material of swirl flow-forming body 3 is aluminium alloy, for example. This swirl flow-forming body 3 is one example of the "holding equipment" in the present invention.

Swirl flow-forming body 3, as illustrated in figs. 4 - 6, is provided with a main body 31, a concave part 32, an end face 33, two jetting ports 34, a slope 35 and two projecting parts 36. Main body 31 has a column shape. End face 33 is formed in a flat shape on one of the surfaces (specifically, the face opposite plate-like member W, which is an article to be conveyed) (hereafter referred to as "bottom face") of main body 31. Concave part 32 has a column shape, and is formed in end face 33. Concave part 32 is formed on the same axis as main body 31.

The two jetting ports 34 are formed on the inner peripheral side surface that faces concave part 32, of main body 31. The two jetting ports 34 are arranged so as to mutually oppose each other. Specifically, the two jetting ports 34 are arranged in point symmetry about the axial centre of the central axis of main body 31 or concave part 32. Liquid supplied to swirl flow-forming body 3 via each of jetting ports 34 is discharged into concave part 32. Slope 35 is formed at the opening of concave part 32.

Each the two projecting parts 36 has a triangular cylinder shape, the cross section of which is an approximate equilateral triangle, and is formed on the wall surface of main body 31, which wall surface faces concave part 32. Specifically, each of the two projecting parts 36 is formed on the inner peripheral side surface of main body 31 that faces concave part 32. Each of projecting parts 36 is arranged at the same depth as jetting ports 34 within concave part 32. The two projecting parts 36 are arranged in point symmetry about the axial centre of the central axis of main body 31 or concave part 32. The two projecting parts 36 and two jetting ports 34 are arranged at equal intervals. Each of projecting parts 36 is arranged so that one rectangular surface thereof comes into contact with the wall surface of main body 31. At this time, the slope that faces concave part 32 is arranged so as to face the swirl direction of the swirl flow formed within said concave part 32. Each of projecting parts 36 is one example of the "liquid supply means" as in the present invention.

Swirl flow-forming body 3, as illustrated in figs. 5 and 6, is also provided with an annular passage 37, a communication passage 38, a supply port 39 and two supply paths 40. Annular passage 37 has a cylindrical shape and is formed inside main body 31 so as to surround concave part 32. Annular passage 37 is formed on the same axis as concave part 32. Annular passage 37 supplies supply path 40 with liquid supplied from communication passage 38. Communication passage 38 is provided inside main body 31, and extends in a straight line parallel to the central axis of main body 31. Communication passage 38 communicates with annular passage 37 at one end thereof, and communicates with supply port 39 at the other end thereof. Supply port 39 has a circular shape, and is provided in the top face of main body 31. Supply port 39 is connected to liquid supply equipment (not illustrated) via a tube, for example, and liquid is supplied into main body 31 via this supply port 39.

Each of the two supply paths 40 discharges liquid into concave part 32 via jetting ports 34 to form a swirl flow within concave part 32. Specifically, each of supply paths 40 is formed so as to extend approximately parallel to end face 33 and in a direction tangential to the outer circumference of concave part 32, one end thereof communicating with annular passage 37 and the other end communicating with jetting ports 34. Supply path 40 is one example of the "fluid passage" in the present invention.

When liquid is supplied to swirl flow-forming body 3 described in the foregoing via supply port 39, the liquid passes through communication passage 38, annular passage 37, and supply path 40 to be discharged into concave part 32 via jetting port 34. The liquid discharged into concave part 32 forms a swirl flow and is straightened in the concave part, and subsequently flows out from the opening of the concave part. In that situation, if plate-like member W is positioned opposite end face 23, flow of outside fluid (for example, air or water) into concave part 32 is restricted. In addition, since a centrifugal force of the swirl flow develops, and entrainment occurs, fluid molecules per unit volume in the center of the swirl flow become less dense; namely, a negative pressure is generated between swirl flow-forming body 3 and plate-like member W. As a result, plate-like member W is pushed toward end face 33 by surrounding fluid. On the other hand, as the distance between plate-like member W and end face 33 decreases, an amount of liquid flowing out of concave part 32 decreases, and the speed of a liquid discharged into concave part 32 through jetting port 34 decreases, and pressure in the centre of the swirl flow increases. Accordingly, plate-like member W does not come into contact with end face 33, and a given distance is maintained between the plate-like member and the end face.

If plate-like member W is conveyed by swirl flow-forming body 3 in a washed and wet state, a swirl flow forms within concave part 32 as described above, and thus liquid adhered to plate-like member W scatters in the outer-circumferential direction due to the centrifugal force of said swirl flow. As a result, in conveyance equipment that uses a conventional circulation flow, there was a problem of the surface of plate-like member becoming dry, and so-called water marks (in other words, water staining) forming on said surface. This is the same as the explanation in the description of the first embodiment above.

By contrast, in swirl flow-forming body 3 in the present embodiment, since projecting part 36 is formed on the inner peripheral side surface of main body 31 that faces concave part 32, liquid discharged from jetting ports 34 and that collides with projecting part 36 scatters within concave part 32. The scattered liquid adheres to the surface of plate-like member W that opposes swirl flow-forming body 3. For example, if the scattered liquid adheres to the central part of the surface of plate-like member W (in other words, the surface part of plate-like member, which part faces the centre of the swirl flow), said liquid spreads to the entire surface of plate-like member W due to the centrifugal force of the swirl flow. As a result, drying of the surface of plate-like member W is prevented, thereby preventing water marks from forming.

### 3. Third embodiment

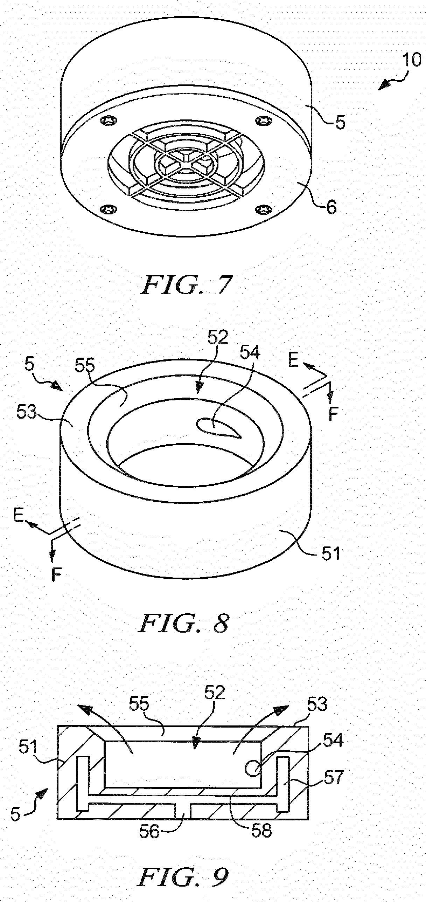

Fig. 7 is a perspective view of conveyance equipment 10 as in a third embodiment of the present invention. Conveyance equipment 10 is equipment for holding a plate-like member W such as a semiconductor wafer or a glass base body and conveying the member. Conveyance equipment 10 generates negative pressure between the equipment and plate-like member W by discharging liquid such as pure water or carbonated water to hold said member. The material of conveyance equipment 10 is an aluminium alloy, for example. Conveyance equipment 10, as illustrated in fig. 7, is provided with a swirl flow-forming body 5 and a baffle plate 6. This conveyance equipment 10 is one example of the "holding equipment" in the present invention.

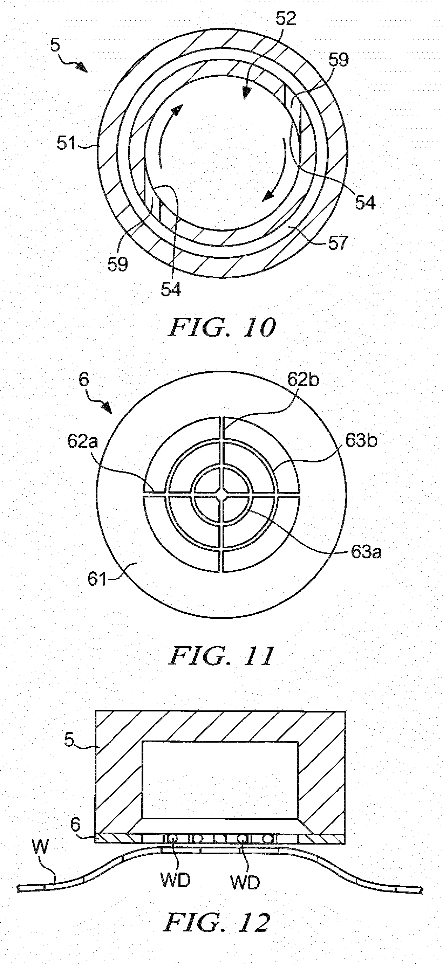

Fig. 8 is a perspective view illustrating one example of swirl flow-forming body 5. Fig. 9 is a cross-sectional view of fig. 8 along line E-E. Fig. 10 is a cross-sectional view of fig. 8 along line F-F. Swirl flow-forming body 5 is equipment that exerts suction on plate-like member W. Swirl flow-forming body 5, as illustrated in figs. 8 - 10, is provided with a main body 51, a concave part 52, an end face 53, two jetting ports 54 and a slope 55. Main body 51 has a column shape. End face 53 is formed in a flat shape on one of the surfaces (specifically, the surface that faces plate-like member W, which is an article to be conveyed) of main body 51. Concave part 52 has a column shape, and is formed in end face 53. Concave part 52 is formed on the same axis as main body 51.

The two jetting ports 54 are formed on the inner peripheral side surface of main body 51 that faces concave part 52. The two jetting ports 54 are arranged in mutual opposition to each other. Specifically, the two jetting ports 54 are arranged in point symmetry about the axial centre of the central axis of main body 51 or concave part 52. Liquid supplied to swirl flow-forming body 5 via each of jetting ports 54 is discharged into concave part 52. Slope 55 is formed at the opening of concave part 52.

Swirl flow-forming body 5, as illustrated in figs. 9 and 10, is also provided with a supply port 56, an annular passage 57, a communication passage 58 and two supply paths 59. Supply port 56 has a circular shape, and is provided in the centre of the top face (that is, the surface opposite the bottom face) of main body 51. Supply port 56 is connected to liquid supply equipment (not illustrated) via a tube, for example, and liquid is supplied into main body 51 via this supply port 56. Annular passage 57 has a cylindrical shape and is formed inside main body 51 so as to surround concave part 52. Annular passage 57 is formed on the same axis as concave part 52. Annular passage 57 supplies supply path 59 with liquid supplied from communication passage 58. Communication passage 58 is provided inside main body 51, and extends in a straight line in a radial direction of the bottom face or top face of main body 51.

Communication passage 58 communicates with annular passage 57 at both ends thereof. Communication passage 58 supplies annular passage 57 with liquid supplied into main body 51 via supply port 56. Each of the two supply paths 59 discharges liquid into concave part 52 via jetting ports 54 to form a swirl flow within concave part 52. Specifically, each of supply paths 59 is formed so as to extend approximately parallel to end surface 53 and in a direction tangential to the outer circumference of concave part 52, one end thereof communicating with annular passage 57 and the other end thereof communicating with jetting ports 54. Supply path 59 is one example of the "fluid passage" in the present invention.

Fig. 11 is a plane view of baffle plate 6. Baffle plate 6 is a member for prohibiting plate-like member W on which suction is exerted due to swirl flow-forming body 5 from entering concave part 52. Baffle plate 6, as illustrated in fig. 11, has a circular shape, and is attached to swirl flow-forming body 5 so as to be concentric with end face 53. Baffle plate 6 is attached to swirl flow-forming body 5 by screwing, for example. Baffle plate 6, as illustrated in fig. 11, is provided with a disk part 61 having a circular opening, two rod-like members 62a, 62b (hereafter collectively referred to as "rod-like member 62") that extend across the opening of disk part 61, and two annular members 63a, 63b (hereafter collectively referred to as "annular member 63") that extend between rod-like members 62a, 62b. This baffle plate 6 is one example of the "liquid supply means" in the present invention.

When baffle plate 6 is attached to swirl flow-forming body 5, one end of disk part 61 comes into contact with end face 53 of swirl flow-forming body 5. Rod-like members 62a and 62b extend so as to cross each other at the centre of the opening of disk part 61. Rod-like members 62a and 62b become extended across the opening of concave part 52 when baffle plate 6 is attached to swirl flow-forming body 5. Rod-like members 62a and 62b extend so as to form a cross. Annular members 63a and 63b extend in a concentric manner about the intersection of rod-like members 62a and 62b.

A gap is provided between the innermost annular member 63a and the intersection of rod-like members 62a and 62b. That is, annular member 63a is provided so as not to cover the centre of the opening of concave part 52 when baffle plate 6 is attached to swirl flow-forming body 5. Consequently, annular member 62a does not obstruct inflow of fluid that is sucked into concave part 5 for a reason described below.

If swirl flow-forming body 5 is supplied with liquid via supply port 56 as explained above, the liquid passes through communication passage 58, annular passage 57 and supply path 59 before being discharged from jetting ports 54 into concave part 52. The liquid discharged into concave part 52 forms a swirl flow and is straightened in concave part 52, and subsequently flows out from the opening of concave part 52. At this time, if a plate-like member W is positioned opposite end face 53, inflow of external fluid (for example, air or water) to concave part 52 is restricted, and the density of fluid molecules per unit volume in the centre of the swirl flow is reduced due to centrifugal force of the swirl flow and entrainment effect, generating negative pressure between swirl flow-forming body 5 and plate-like member W. As a result, plate-like member W is pushed by surrounding fluid and is drawn towards end face 53. On the other hand, as the distance between end face 53 and plate-like member W decreases, the amount of fluid that flows out of concave part 52 is limited, the speed of fluid discharged from jetting ports 54 into concave part 52 decreases, and the pressure in the centre of the swirl flow increases. As a result, plate-like member W does not come into contact with end face 53, and a given distance is maintained between plate-like member W and end face 53.

However, if plate-like member W is a member to which it is difficult to apply suction, plate-like member W and baffle plate 6 sometimes come into contact with each other. Here, a material to which it is difficult to apply suction is a material that is soft, permeable and heavy. When conveying a material to which it is difficult to apply suction, there is no option but to increase the suction power of swirl flow-forming body 5, and as a result, plate-like member W and baffle plate 6 sometimes come into contact with each other. However, due to the presence of baffle plate 6, plate-like member W is not sucked into concave part 52. Therefore, plate-like member W is prevented from coming into contact with the opening edge of concave part 52, whereby damage to plate-like member W is prevented.

If plate-like member W is conveyed by swirl flow-forming body 5 in a washed and wet state, a swirl flow is formed within concave part 52 as described above, and thus liquid adhered to plate-like member W scatters in an outer-circumferential direction thereof due to the centrifugal force of said swirl flow. As a result, with conveyance equipment that applies a conventional swirl flow, the surface of plate-like member W becomes dry, forming so-called water marks on said surface, which was problematic. This is described in the explanation of the first embodiment.

By contrast, in conveyance equipment 10 in the present embodiment, since baffle plate 6 is attached to swirl flow-forming body 5, scattering in the outer-circumferential direction of liquid adhered to plate-like member W is hindered. Fig. 12 is a drawing explaining the effects of baffle plate 6. As illustrated in fig. 12, scattering of particles WD of liquid adhered to plate-like member W in the outer-circumferential direction is hindered due to annular member 63 of baffle plate 6. In other words, particles WD of the liquid are held in a position opposing plate-like member W by annular member 63 of baffle plate 6. For example, particles WD of liquid adhered to the central part of the surface of plate-like member W (in other words, the surface part of plate-like member W, which part faces the central part of the swirl flow) are held in said position by annular member 63 of baffle plate 6. As a result, drying of the surface of plate-like member W is prevented, thereby preventing formation of water marks.

### 4. Modified example

The embodiments described above may be modified as follows. Two or more of the modified examples below may be combined with one another.

### 4-1. Modified example 1

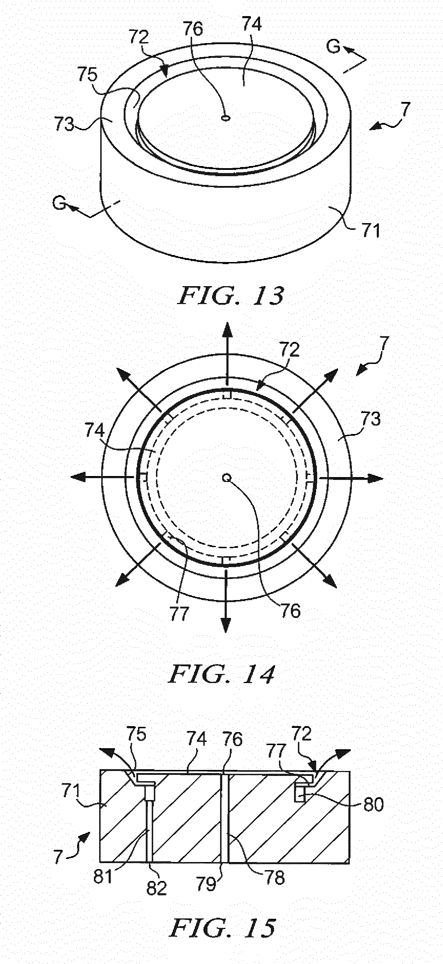

Concerning swirl flow-forming body 1 as in the first embodiment described above, a swirl flow is formed, but the "liquid supply means" as in the present invention may be provided in a radial flow-forming body that forms a radial flow. Fig. 13 is a perspective view illustrating one example of a radial flow-forming body 7 as in the present modified example. As illustrated in fig. 13, radial flow-forming body 7 is provided with a main body 71, an annular concave part 72, an end face 73, an opposing surface 74, a slope 75 and a discharge port 76. Main body 71 has a column shape. End face 73 is formed in a flat manner on one of the surfaces (specifically, the surface that faces plate-like member W, which is an article to be conveyed) (hereafter referred to as "bottom face") of main body 71. Annular concave part 72 is formed in end face 73. Annular concave part 72 is formed concentrically with the outer circumference of main body 71. Opposing surface 74 is formed in a flat manner on the bottom surface of main body 71. Opposing surface 74 is a surface surrounded by annular concave part 72, and opposes plate-like member W, which is an article to be conveyed. Opposing surface 74 is formed in a recessed manner with respect to end face 73 on the bottom surface of main body 71. Slope 75 is formed at the opening of annular concave part 72 (specifically, the outer-circumferential edge thereof). Discharge port 76 has a circular shape, and is provided in the centre of opposing surface 74. This discharge port 76 communicates with an introduction path 78 described below, and discharges liquid such as pure water or carbonated water.

Fig. 14 is a bottom view of radial flow-forming body 7. Fig. 15 is a cross-sectional view of fig. 13 along line G-G. As illustrated in figs. 14 and 15, radial flow-forming body 7 is further provided with six nozzle holes 77, an introduction path 78, an introduction port 79, an annular passage 80, a communication passage 81 and a supply port 82. Introduction port 79 has a circular shape, and is provided in the centre of the top face (that is, the surface opposite the bottom face) of main body 71. Introduction port 79 is connected to a liquid tank (not illustrated) via a tube, for example, and liquid is supplied into main body 71 via this introduction port 79. Introduction path 78 is provided inside main body 71, and extends in a straight line along the central axis of main body 71. Introduction path 78 communicates with introduction port 79 at one end thereof, and communicates with the discharge port 76 described above at the other end thereof.

Annular passage 80 has a cylindrical shape, and is formed inside main body 71. Annular passage 80 is formed on the same axis as main body 71. Annular passage 80 supplies fluid provided from communication passage 81 to nozzle holes 77. Communication passage 81 is provided inside main body 71, and extends in a straight line parallel to the central shaft of main body 71. Communication passage 81 communicates with annular passage 80 at one end thereof, and communicates with supply port 82 at the other end thereof. Supply port 82 has a circular shape, and is provided at the top face of main body 71. Supply port 82 is connected to fluid supply equipment (not illustrated) via a tube, for example, and fluid is supplied into main body 71 via this supply port 82.

Each of the six nozzle holes 77 discharges liquid into annular concave part 72 and forms a radial flow. Specifically, each of the nozzle holes 77 is formed so as to be approximately parallel to end face 73 or opposing surface 74 and to extend in a straight line in the radial direction of the bottom face or top face of main body 71, one end thereof communicating with annular passage 80 and the other end communicating with concave part 72. The six nozzle holes 77 are arranged on the same plane so that lines extending radially from the center of radial flow-forming body 7 through adjacent nozzle holes 77 form an approximately 45 degree angle with one another. Each of the nozzle holes 77 is one example of the "fluid passage" in the present invention.

If radial flow-forming body 7, as explained above, is supplied with fluid via supply port 82, the fluid passes through communication passage 81 and annular passage 80 before being discharged into annular concave part 72 from nozzle holes 77. Fluid discharged into annular concave part 72 flows out of the opening of annular concave part 72. At this time, if a plate-like member W is positioned opposite opposing surface 74, inflow of external fluid (for example, air or water) to the space between opposing surface 74 and plate-like member W is limited, and the density of fluid molecules per unit volume in this space becomes reduced due to entrainment effect of the radial flow, generating negative pressure. As a result, plate-like member W is pushed by surrounding fluid and is drawn towards end face 73. On the other hand, as the distance between end face 73 and plate-like member W decreases, the amount of fluid that flows out of annular concave part 72 becomes limited, the speed of fluid discharged from nozzle holes 77 into concave part 72 decreases, and the pressure in said space increases. As a result, plate-like member W does not come into contact with end face 73, and a given distance is maintained between plate-like member W and end face 73.

If plate-like member W is conveyed by radial flow-forming body 7 in a washed and wet state, a radial flow is formed by nozzle holes 77, and thus liquid adhered to plate-like member W scatters in the outer-circumferential direction thereof due to this radial flow. As a result, with conveyance equipment that applies a conventional radial flow, there is a problem in which the surface of plate-like member W becomes dry, and a so-called water mark forms on said surface.

By contrast, with radial flow-forming body 7 in the present modified example, liquid inside introduction path 78 is discharged from discharge port 76 by suction exerted by the negative pressure that occurs between radial flow-forming body 7 and plate-like member W. This discharged liquid is supplied to the surface (specifically, the central part of the surface) of plate-like member W that opposes discharge port 76. In other words, said liquid is supplied to the part of the surface of plate-like member W, which part faces the radial centre of the radial flow. Here, the radial centre is the centre of a circle on the periphery of which the six nozzle holes 77 are arranged, for example. Said liquid is directly supplied from directly above the central part of said surface via discharge port 76. Liquid supplied to the central part of the surface of plate-like member W is drawn towards the member by the radial flow and spreads to the entire surface of plate-like member W. As a result, drying of the surface of plate-like member W is prevented, thereby preventing the formation of water marks.

In radial flow-forming body 7, the combination of discharge port 76, introduction port 79 and introduction path 78 is one example of the "liquid supply means" in the present invention.

The configuration of radial flow-forming body 7 (in particular, the number of nozzle holes 77 and configuration of the fluid flow path inside main body 71) is not limited to the example indicated in the present modified example. Said configuration may be determined in accordance with the size, shape and material of plate-like member W that is conveyed by radial flow-forming body 7.

### 4-2. Modified example 2

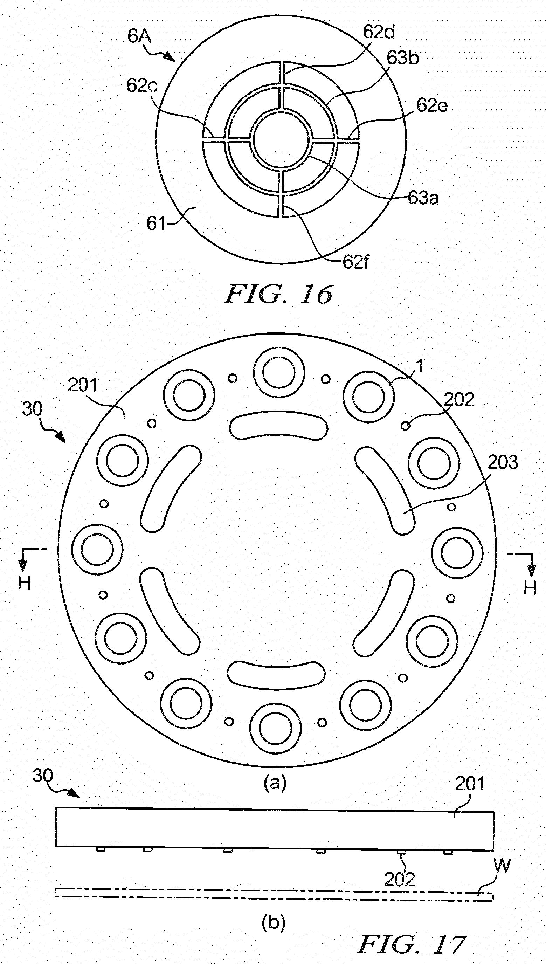

The shape of baffle plate 6 is not limited to the shape in the example indicated in the third embodiment described above. For example, as illustrated in fig. 16, it is possible to adopt a configuration in which the portion of rod-like members 62a and 62b in the region inside annular member 63a arranged on the innermost side has been removed, compared to baffle plate 6 in the third embodiment described above. A baffle plate 6A having this shape, as illustrated in fig. 16, has a disk part 61, rod-like members 62c, 62d, 62e and 62f, and annular members 63a and 63b.

Rod-like members 62c, 62d, 62e and 62f are the same length, each extending from the edge of the opening of disk part 61 towards the centre of the opening thereof. Each of rod-like members 62c, 62d, 62e and 62f extends perpendicularly with respect to adjacent rod-like members. Annular member 23a is arranged so that the outer-circumferential edge thereof comes into contact with the tip of each of the rod-like members 22c, 22d, 22e and 22f. Annular member 63a is arranged so that the outer-circumferential edge thereof comes into contact with the tip of each of the rod-like members 62c, 62d, 62e and 62f. Annular member 63b extends between each of the rod-like members 62c, 62d, 62e and 62f so as to be concentric with annular member 63a. Baffle plate 6 may have a lattice shape.

### 4-3. Modified example 3

Depending on the size of plate-like member W, a plurality of swirl flow-forming bodies 1, as in the first embodiment described above, may be attached to a plate-like frame. Fig. 17 is a drawing illustrating one example of the configuration of conveyance equipment 30 as in the present modified example. Specifically, fig. 17(a) is a bottom view of conveyance equipment 30, and fig. 17(b) is a side view of conveyance equipment 30. Conveyance equipment 30, as illustrated in fig. 17, is provided with a base body 201, twelve swirl flow-forming bodies 1, twelve friction members 202 and six holes 203.

Base body 201 has a disk shape. The material of base body 201 is an aluminium alloy, for example. The twelve swirl flow-forming bodies 1 are provided on one of the surfaces (specifically, the surface that opposes plate-like member W, which is an article to be conveyed) (Hereafter referred to as "bottom face") of base body 201. The twelve swirl flow-forming bodies 1 are arranged on the circumference of the same circle on said bottom face. The twelve swirl flow-forming bodies 1 are arranged at equal intervals along the outer circumference of base body 201.

Each of the twelve friction members 202 has a column shape, and is provided on the bottom face of base body 201. The twelve friction members 202 are arranged at equal intervals on the circumference of the same circle as the circle on which swirl flow-forming bodies 1 are arranged, on said bottom face. One friction member 202 is arranged between two swirl flow-forming bodies 1. Each of the friction members 202 is a member that comes into contact with the surface of plate-like member W, which is an article to be conveyed, and prevents any movement of plate-like member W due to friction that occurs between the member and said surface. The material of each of the friction members 202 is fluororubber, for example. The six holes 203 are through holes having an elongated shape with rounded ends provided in base body 201. The six holes 203 are arranged at equal intervals on the circumference of the same circle in base body 201. The circle on the circumference of which holes 203 are arranged is concentric with the circle on the circumference of which swirl flow-forming bodies 1 are arranged. Holes 203 are arranged nearer to the centre of the surface of base body 201 than swirl flow-forming bodies 1.

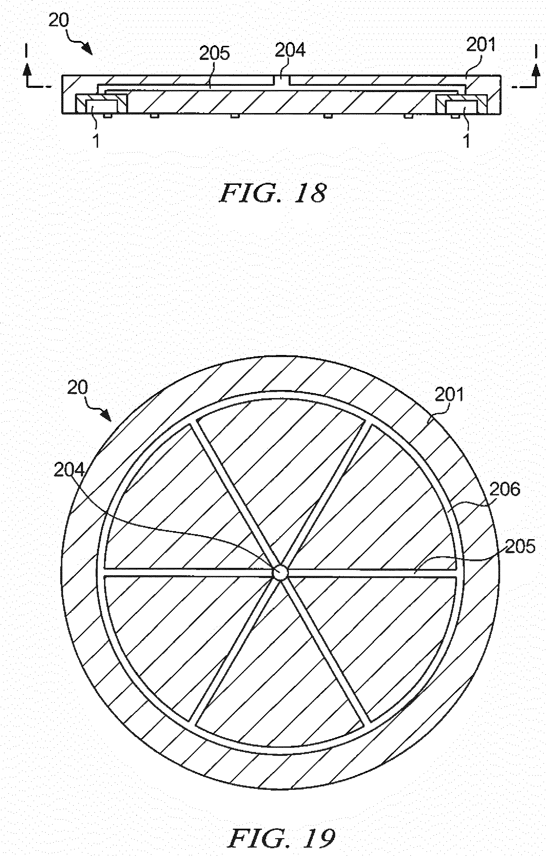

Fig. 18 is a cross-sectional view of fig. 17 along line H-H. Fig. 19 is a cross-sectional view of fig. 18 along line I-I. As illustrated in figs. 18 and 19, base body 201 is provided with supply port 204, three communication passages 205 and an annular passage 206. Supply port 204 has a circular shape and is provided in the centre of the top face (that is, the surface opposite the bottom face) of base body 201. Supply port 204 is connected to fluid supply equipment (not illustrated) via a tube, and fluid is supplied into base body 201 via this supply port 204. The three communication passages 205 are provided inside base body 201, and extend in a straight line in the radial direction of the bottom face or top face of base body 201. The three communication passages 205 are arranged on the same plane so that adjacent communication passages 205 form an approximately 60 degree angle with each other. Each of communication passages 205 communicates with annular passage 206 at both ends thereof. Each of communication passages 205 supplies annular passage 206 with fluid that is supplied into base body 201 via supply port 204. Annular passage 206 is provided inside base body 201, and is arranged on the circumference of the same circle as the circle on which swirl flow-forming bodies 1 are arranged. Annular passage 206 supplies each of swirl flow-forming bodies 1 with fluid supplied from communication passage 205.

In conveyance equipment 30, swirl flow-forming body 3, conveyance equipment 10 or radial flow-forming body 7 may be attached in place of swirl flow-forming body 1.

### 4-4. Modified example 4

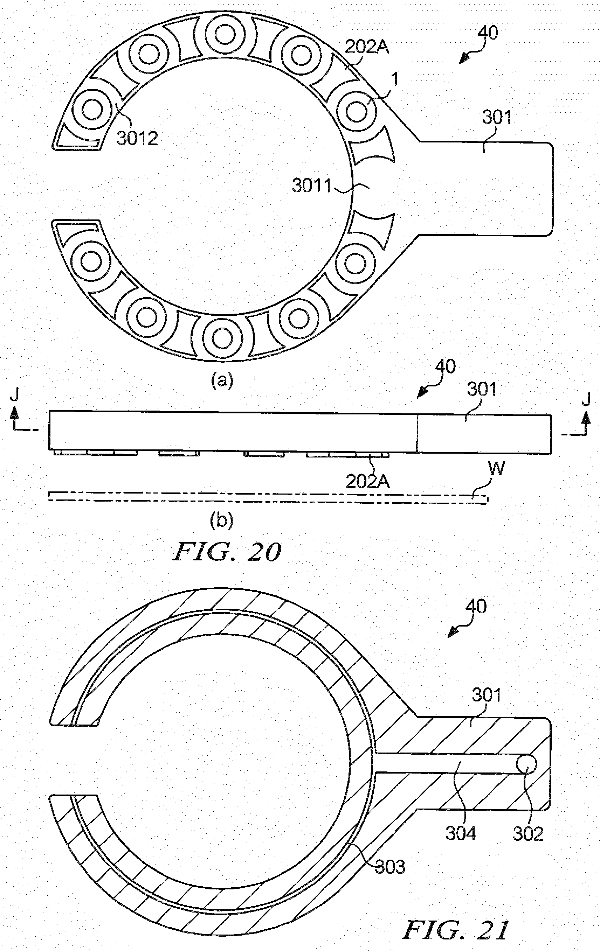

In modified example 1 described above, the shape of conveyance equipment 30 may be modified. Fig. 20 is a drawing illustrating one example of the configuration of conveyance equipment 50 as in the present modified example. Specifically, fig. 20(a) is a bottom view of conveyance equipment 50, and fig. 20(b) is a side view of conveyance equipment 50. Conveyance equipment 50, as illustrated in fig. 20, is provided with a base body 301, ten swirl flow-forming bodies 1, and twelve friction members 202A.

Base body 301 is a plate-like member in the shape of a two-pronged fork, and consists of a rectangular holding part 3011 and two arms 3012 that branch out from holding part 3011. The material of base body 301 is an aluminium alloy, for example. The ten swirl flow-forming bodies 1 are provided on one of the surfaces (specifically, the surface that opposes plate-like member W, which is an article to be conveyed) (hereafter referred to as "bottom face") of the two arms 3012 that constitute base body 301. The ten swirl flow-forming bodies 1 are provided on the same circumference on the two arms 3012. Five swirl flow-forming bodies 1 are arranged at equal intervals per arm 3012.

The twelve friction members 202A are plate-like members, and are provided on the bottom faces of the two arms 3012. The twelve friction members 202A are arranged on the circumference of the same circle as the circle on which swirl flow-forming bodies 1 are arranged, on said bottom faces. On each arm 3012, arrangement is made so that two friction members 202A sandwich one swirl flow-forming body 1. Each of the friction members 202A comes into contact with the surface of plate-like member W, which is an article to be conveyed, and prevents movement of plate-like member W using friction that occurs between the member and said surface. The material of each of the friction members 202A is fluororubber, for example.

Fig. 21 is a cross-sectional view of fig. 20 along line J-J. As illustrated in fig. 21, base body 301 is provided with a supply port 302, a C-shaped passage 303 and a communication passage 304. Supply port 302 has a circular shape, and is provided at the top face (that is, the surface opposite the bottom face) of holding part 3011. Supply port 302 is connected to fluid supply equipment (not illustrated) via a tube, and fluid is supplied into base body 301 via this supply port 302. Communication passage 304 is provided inside holding part 3011, and extends in a straight line long the longitudinal direction of holding part 3011. Communication passage 304 communicates with supply port 302 at one end thereof, and communicates with C-shaped passage 303 at the other end thereof. C-shaped passage 303 is provided inside holding part 3011 and the two arms 3012. C-shaped passage 303 is arranged on the circumference of the same circle as the circle on which swirl flow-forming bodies 1 are arranged. C-shaped passage 303 supplies liquid supplied from communication passage 304 to each of swirl flow-forming bodies 1.

In conveyance equipment 50, swirl flow-forming body 3, conveyance equipment 10 or radial flow-forming body 7 may be attached in place of swirl flow-forming body 1.

### 4-5. Modified example 5

The configuration of base body 201 of conveyance equipment 30 described above (in particular, the configuration of the fluid flow path within base body 201) is not limited to the example indicated in modified example 3 described above. The number, shape and arrangement of friction members 202 and holes 203 provided on the base body of conveyance equipment 30 are not limited to those in the example indicated in modified example 3 described above. These elements may be determined in accordance with the size, shape and material of plate-like member W conveyed by conveyance equipment 30. Friction members 202 and holes 203 are not necessarily provided on base body 201 of conveyance equipment 30. If friction members 202 are not provided on base body 201 of conveyance equipment 30, a well-known centering guide (for example, refer to published unexamined patent application number 2005-51260) may be arranged on base body 201 to determine the position of plate-like member W. Similarly, the configuration of base body 301 of conveyance equipment 50 described above (in particular, the configuration of the fluid flow path within substrate 301) is not limited to the example indicated in modified example 4 described above.

### 4-6. Modified example 6

The number, configuration and arrangement of swirl flow-forming bodies 1 provided on base body 201 of conveyance equipment 30 described above are not limited to those in the example indicated in modified example 3 described above. These elements may be determined in accordance with the size, shape and material of plate-like member W conveyed by conveyance equipment 30. For example, the number of swirl flow-forming bodies 1 may be less than or more than twelve. Swirl flow-forming bodies 1 may be arranged along the outer circumference of base body 201 in two or more rows. The rotational direction of the swirl flows formed by swirl flow-forming bodies 1 may differ from one another. The fluid (liquid or gas) discharged may be changed for each swirl flow-forming body 1. Similarly, the number, configuration and arrangement of swirl flow-forming bodies 1 arranged on base body 301 of conveyance equipment 50 described above are not limited to those in the example indicated in modified example 4 described above.

### 4-7. Modified example 7

The shape of main body 11 of swirl flow-forming body 1 is not limited to a cylinder, and may be a square pillar shape or an elliptical pillar shape. Concerning the configuration of the fluid flow path formed inside main body 11 of swirl flow-forming body 1, supply port 22 and supply path 23 may be connected directly by one passage without providing annular passage 20 and communication passage 21. Slope 15 is not necessarily provided (that is, the end part of end face 13 is not necessarily chamfered). The number of supply paths 23 provided in swirl flow-forming body I is not limited to two, and may be one or more than two. If the number of supply paths 23 is two or more, the fluid (liquid or gas) discharged may be changed for each supply path 23. The modifications described above may be adopted in swirl flow-forming body 3 and swirl flow-forming body 5.

### 4-8. Modified example 8

The shape of convex part 16 of swirl flow-forming body 1 is not limited to the shape in the example indicated in the first embodiment described above. For example, the top face of convex part 16 may be formed on the same plane as end face 13. A discharge port 17 may be provided in the centre of the bottom of concave part 32 without providing convex part 16. The number, shape and arrangement of introduction paths 19 are not limited to those in the example indicated in the first embodiment described above. Introduction part 18 may be connected to a liquid supply pump (not illustrated) in place of the liquid tank via a tube, for example, and the liquid inside the introduction paths 19 may be pushed out into concave part 12 by the pump.

### 4-9. Modified example 9

The number, shape and arrangement of projecting parts 36 are not limited to those in the example indicated in the second embodiment described above. For example, the number of projecting parts 36 may be one or more than two. The shape of projecting parts 36 may be another shape such as a cylinder, a cone, a pyramid, a rectangular parallelepiped, or a sphere. Projecting parts 36 may be provided on the bottom of concave part 32.

### 4-10. Modified example 10

Baffle plate 6 of conveyance equipment 10 may be attached to end face 13 of swirl flow-forming body 1, end face 33 of swirl flow-forming body 3 or end face 73 of radial flow-forming body 7. A convex part may be provided on the bottom face of concave part 52 of swirl flow-forming body 5 of conveyance equipment 10 similarly to swirl flow-forming body 1. Swirl flow-forming body 5 of conveyance equipment 10 may be replaced with a non-contact chuck (for example, refer to published unexamined patent application number 2011-138948) provided with a well-known electric fan.

## Claims

1. Holding equipment for holding a plate-like member by discharging fluid to generate a negative pressure between the holding equipment and the member, the holding equipment comprising:
a columnar main body;
a flat end face formed at the main body, that faces the member;
a concave part formed at the end face;
one or more fluid passages that discharge fluid into the concave part to form a swirl flow or a radial flow; and
a liquid supply means for supplying a part of the member with a liquid, the part facing the centre of the swirl flow or the radial centre of the radial flow.

2. The holding equipment according to Claim 1, wherein:
the liquid supply means comprises a discharge port that faces the part of the member; and
the liquid supply means discharges liquid onto the part of the member via the discharge port.

3. The holding equipment according to Claim 2, wherein liquid that is discharged onto the part of the member via the discharge port is discharged onto the part of the member by suction exerted by the negative pressure that occurs between the holding equipment and the member.

4. The holding equipment according to Claim 1, wherein:
the one or more fluid passages discharge liquid into the concave part to form a swirl flow; and
the liquid supply means is a projecting part formed on a wall surface of the main body, the wall surface facing the concave part.

5. The holding equipment according to Claim 1, wherein:
the one or more fluid passages discharge liquid into the concave part to form a swirl flow or a radial flow; and
the liquid supply means is attached to the end face, and holds liquid particles discharged by the one or more fluid passages, in a position that faces the part of the member.

6. The holding equipment according to Claim 1, wherein the fluid is a gas.
